# EUROPÄISCHE PATENTSCHRIFT

(11) **EP 2 542 902 B1**
(45) Veröffentlichungstag und Bekanntmachung des Hinweises auf die Patenterteilung: **05.03.2014**
(21) Anmeldenummer: 11701746.7
(22) Anmeldetag: 17.01.2011
(51) Int. Cl.: G01R 1/20, G01R 19/03, G01R 21/02

(54) **ELEKTRONISCHES BAUELEMENT, STROMSENSOR**
ELECTRONIC COMPONENT, CURRENT SENSOR
COMPOSANT ÉLECTRONIQUE, CAPTEUR DE COURANT

(30) Priorität: 02.03.2010 DE 102010009835
(43) Veröffentlichungstag der Anmeldung: 09.01.2013
(73) Patentinhaber: Isabellenhütte Heusler GmbH & Co. Kg, 35683 Dillenburg (DE)
(72) Erfinder: HETZLER, Ullrich, 35688 Dillenburg-Oberscheld (DE)
(74) Vertreter: Beier, Ralph
(86) Internationale Anmeldenummer: PCT/EP2011/000170
(87) Internationale Veröffentlichungsnummer: WO 2011/107184

(56) Entgegenhaltungen:
- EP-A2- 1 030 185
- WO-A1-97/17616
- DE-A1- 4 243 349
- DE-U1-202006 003 595
- US-A- 1 407 147
- US-A- 3 477 880
- US-B2- 6 639 395

## Beschreibung

Die Erfindung betrifft ein elektronisches Bauelement, nämlich-einen Stromsensor.

Derartige Strommesswiderstände sind beispielsweise aus EP 0 605 800 A1 und EP 1 253 430 A1 bekannt und ermöglichen die Messung eines elektrischen Stroms entsprechend der Vierleitertechnik. Dabei wird der zu messende elektrische Strom über zwei Anschlusskontakte durch den Strommesswiderstand hindurchgeleitet, wobei über zwei weitere Anschlusskontakte die elektrische Spannung gemessen wird, die über dem Widerstandselement des Strommesswiderstands abfällt. Aus der gemessenen Spannung kann dann nach dem Ohmschen Gesetz der elektrische Strom berechnet werden, der durch den Strommesswiderstand fließt.

Aus EP 1 253 430 A1 ist weiterhin bekannt, dass ein Messwerterfassungssystem in Form eines ASICs (ASIC: Application Specific Integrated Circuit) direkt auf dem Strommesswiderstand angebracht wird, so dass der Strommesswiderstand zusammen mit dem ASIC ein Strommessmodul bildet. Die Strommessung mit derartigen Strommessmodulen hat den Vorteil einer sehr großen Messgenauigkeit und eines geringen Bauvolumens, jedoch sind derartige Strommessmodule teuer und werden deshalb nur für Präzisionsanwendungen eingesetzt, bei denen die hohe Messgenauigkeit wichtig ist.

Im industriellen Bereich gibt es jedoch zahlreiche Anwendungen (z.B. Stromgrenzwertschalter, elektronische Sicherungen, u.a.), bei denen nur eine Überwachungsfunktion benötigt wird, wohingegen die Genauigkeit der Strommessung weniger wichtig ist. Bei einigen Anwendungen ist es sogar wünschenswert, dass die Strommessung nur langsam auf Änderungen des zu messenden elektrischen Stroms anspricht, um ein unnötig häufiges Abschalten bei kurzen Stromspitzen zu verhindern. Es kann deshalb wünschenswert sein, dass die Strommessung auf zeitliche Änderung des zu messenden Stroms mit einer Zeitkonstante im Sekundenbereich anspricht. Außerdem sollte sowohl Gleichstrom als auch Wechselstrom messbar sein, wie beispielsweise ein 50 Hertz-Wechselstrom, ein durch Schaltvorgänge stark verzerrter Wechselstrom oder sogar ein hochfrequenter Wechselstrom.

Ferner ist zum Stand der Technik hinzuweisen auf US 3 026 363. Dieses Patent offenbart ein Bauelement zur Messung des zeitlichen Mittelwerts eines elektrischen Signals, wie beispielsweise eines Breitbandsignals. Hierbei erfolgt zwar ebenfalls eine Temperaturmessung mittels eines Thermoelements, jedoch wird nicht die Temperaturdifferenz zwischen dem Widerstandselement und dessen Anschlussteilen gemessen.

Weiterhin ist aus DE 10 2004 062 655 A1 ein Strommesswiderstand bekannt, bei dem die Erwärmung des Strommesswiderstands und die daraus resultierende Änderung seines Widerstandswerts berücksichtigt wird, um temperaturbedingte Messfehler zu vermeiden. Auch hierbei wird jedoch nicht die Temperaturdifferenz zwischen dem Widerstandselement und dessen Anschlussteilen gemessen. Diese Patentanmeldung offenbart also lediglich eine Temperaturkompensation bei einem Strommesswiderstand.

Schließlich ist zum allgemeinen technischen Hintergrund noch hinzuweisen auf US 2004/0227522 A1 und US 2010/0040120 A1.

Aus US 1 407 147 A ist ein elektronisches Bauelement gemäß dem Oberbegriff des Hauptanspruchs bekannt. Hierbei wird der durch das elektronische Bauelement fließende Strom nach einem einzigen physikalischen Messprinzip gemessen. Nachteilig daran ist die fehlende Redundanz und die Tatsache, dass die Messung nur mit einer zeitlichen Dynamik erfolgt.

Ferner ist zum Stand der Technik hinzuweisen auf WO 97/17616 A1, DE 42 43 349 A1, US 6 639 395 B2, DE 20 2006 003595 U1, EP 1 030 185 A2, US 3 477 880 A und FR 2 883 380 A1.

Der Erfindung liegt deshalb die Aufgabe zugrunde, eine andere Möglichkeit zur Strommessung zu schaffen, die mit geringeren Kosten verbunden ist und vorzugsweise auch die vorstehend genannten Nachteile beseitigt.

Diese Aufgabe wird durch einen Stromsensor gemäß Anspruch 1 gelöst.

Die Erfindung beruht auf der technischen Erkenntnis, dass im Betrieb eines Stromsensors eine Temperaturdifferenz auftritt zwischen dem aus einem Widerstandsmaterial bestehenden Widerstandselement einerseits und den angrenzenden Anschlussteilen aus einem Leitermaterial andererseits. Diese Temperaturdifferenz rührt daher, dass das Widerstandsmaterial des Widerstandselements in der Regel hochohmiger ist als das Leitermaterial der Anschlussteile, so dass in dem Widerstandselement eine entsprechend größere thermische Verlustleistung umgesetzt wird, die dann über die Anschlussteile thermisch abgeführt wird. Die Temperaturdifferenz zwischen dem Widerstandselement einerseits und den Anschlussteilen andererseits hängt wiederum von der Größe des elektrischen Stroms ab, der durch das Widerstandselement fließt, so dass diese Temperaturdifferenz ein Maß für den elektrischen Strom bildet.

Die Erfindung sieht deshalb eine Temperaturmesseinrichtung vor, welche die Temperaturdifferenz zwischen dem Widerstandselement einerseits und mindestens einem der beiden Anschlussteile andererseits misst, um daraus den zu messenden elektrischen Strom ableiten zu können. Hierbei ist zu erwähnen, dass die Temperaturmesseinrichtung sinnvollerweise galvanisch von den Anschlussteilen und dem Widerstandselement getrennt ist.

In einem bevorzugten Ausführungsbeispiel der Erfindung, bestehend aus Temperatursensoren und Auswertungsschaltung, weist die Temperaturmesseinrichtung mindestens ein vom Shunt elektrisch isoliertes Thermoelement mit einer heißen Kontaktstelle und einer kalten Kontaktstelle auf, wobei die heiße Kontaktstelle das Widerstandselement thermisch kontaktiert, während die kalte Kontaktstelle eines der beiden Anschlussteile thermisch kontaktiert. Das Thermoelement erzeugt dann im bestromten Zustand des Stromsensors eine Thermospannung entsprechend dem Seebeck-Effekt, wobei die gemessene Thermospannung die Temperaturdifferenz und damit ein Maß für den elektrischen Strom bildet. Das Thermoelement weist also Schenkel auf, die vorzugsweise parallel zur Stromrichtung in dem Stromsensor ausgerichtet sind, so dass die heiße Kontaktstelle auf dem Widerstandselement liegt, während die kalte Kontaktstelle auf einem der Anschlussteile liegt.

In dem bevorzugten Ausführungsbeispiel der Erfindung weist die Temperaturmesseinrichtung eine Thermosäule mit mehreren Thermoelementen auf, die elektrisch hintereinandergeschaltet sind. Dies bietet den Vorteil, dass auch relativ geringe Temperaturdifferenzen zwischen dem Widerstandselement einerseits und den Anschlussteilen andererseits zu einer messtechnisch auswertbaren Thermospannung führen, da sich die Thermospannungen der einzelnen Thermoelemente innerhalb der Thermosäule addieren.

Die Thermosäule ist hierbei vorzugsweise so angeordnet, dass die kalten Kontaktstellen der Thermoelemente abwechselnd das erste Anschlussteil und das zweite Anschlussteil thermisch kontaktieren. Es ist jedoch alternativ auch möglich, dass die kalten Kontaktstellen der Thermoelemente der Thermosäule durchgehend nur das erste Anschlussteil oder nur das zweite Anschlussteil thermisch kontaktieren.

Der im Rahmen der Erfindung verwendete Begriff einer thermischen Kontaktierung stellt darauf ab, dass die jeweiligen Kontaktstellen so auf dem Widerstandselement bzw. den Anschlussteilen angebracht sind, dass sich ein geringer Wärmeübergangswiderstand ergibt. Beispielsweise kann diese thermische Kontaktierung erfolgen, indem die heißen bzw. kalten Kontaktstellen mit Hilfe eines wärmeleitenden Klebers auf dem Widerstandselement bzw. den Anschlussteilen festgeklebt werden. Eine andere Möglichkeit zur thermischen Kontaktierung besteht darin, die heißen bzw. kalten Kontaktstellen auf dem Widerstandselement bzw. den Anschlussteilen mittels eines elektrisch isolierenden Trägers festzulöten. Die Erfindung ist jedoch hinsichtlich der thermischen Kontaktierung der heißen bzw. kalten Kontaktstellen nicht auf die vorstehend genannten Beispiele beschränkt, sondern grundsätzlich auch in anderer Weise realisierbar.

In dem bevorzugten Ausführungsbeispiel der Erfindung sind zwei elektrisch von dem Shunt isolierte Thermosäulen vorgesehen, wobei die heißen Kontaktstellen der beiden Thermosäulen jeweils das Widerstandselement thermisch kontaktieren. Bei der ersten Thermosäule kontaktieren die kalten Kontaktstellen das erste Anschlussteil thermisch, wohingegen bei der zweiten Thermosäule die kalten Kontaktstellen das zweite Anschlussteil thermisch kontaktieren. Die erste Thermosäule misst also die Temperaturdifferenz zwischen dem Widerstandselement einerseits und zwischen dem ersten Anschlussteil andererseits. Die zweite Thermosäule misst dagegen die Temperaturdifferenz zwischen dem Widerstandselement und dem zweiten Anschlussteil.

In einer Variante dieses Ausführungsbeispiels sind diese beiden Thermosäulen auf dem Bauelement zu einer Reihenschaltung zusammengeschaltet und mit zwei gemeinsamen Anschlusskontakten auf dem Bauelement verbunden. Die über den beiden Anschlusskontakten abfallende Thermospannung spiegelt also die Summe der beiden Temperaturdifferenzen zwischen dem Widerstandselement und den beiden Anschlussteilen wider.

In einer anderen Variante dieses Ausführungsbeispiels sind die beiden Thermosäulen dagegen auf dem Bauelement elektrisch voneinander getrennt und getrennt voneinander mit jeweils zwei Anschlusskontakten verbunden, um die Thermospannungen der beiden Thermosäulen getrennt voneinander messen zu können. Dies ist dann vorteilhaft, wenn ein Gleichstrom gemessen wird und das Leitermaterial der Anschlussteile thermoelektrisch nicht an das Widerstandsmaterial des Widerstandselements angepasst ist. In diesem Fall entsteht in dem Stromsensor aufgrund des Peltier-Effekts eine asymmetrische Temperaturverteilung von dem Widerstandselement zu den beiden Anschlussteilen. Aus der Differenz der Thermospannungen der beiden Thermosäulen kann dann die Stromrichtung abgeleitet werden, wohingegen der Absolutwert der Summe der beiden Thermospannungen ein Maß für die Größe des zu messenden Stroms bildet.

Es wurde bereits vorstehend erwähnt, dass die heißen Kontaktstellen der Thermoelemente das Widerstandselement thermisch kontaktieren, da das Widerstandselement im bestromten Zustand aufgrund seines größeren spezifischen elektrischen Widerstands heißer ist als die benachbarten Anschlussteile. Die heißen Kontaktstellen der Thermoelemente können hierbei in einer Reihe nebeneinander liegen, wobei die Reihe der heißen Kontaktstellen im Wesentlichen quer zur Stromrichtung in dem elektronischen Bauelement verlaufen kann.

Die Temperatur innerhalb des Widerstandselements ist jedoch in der Regel nicht räumlich konstant, sondern nimmt von einem sogenannten "hot spot" in der Mitte des Widerstandselements in Richtung der angrenzenden Anschlussteile ab. Darüber hinaus ist die Temperatur des Widerstandselements auch in seitlicher Richtung bezüglich der Stromrichtung nicht konstant, sondern nimmt in der Regel von der Mitte des Widerstandselements zu den freiliegenden Rändern hin ab. Es kann deshalb vorteilhaft sein, wenn die heißen Kontaktstellen über das Widerstandselement räumlich verteilt angeordnet sind, damit die Thermosäule einen Mittelwert der Temperatur des Widerstandselements misst, wodurch die Messung verbessert werden kann.

Bei der indirekten Strommessung durch eine Temperaturmessung handelt es sich in der Regel um ein relativ träges Messverfahren, was bei bestimmten Anwendungen vorteilhaft sein kann, um ein unnötige häufiges Abschalten bei kurzzeitigen Stromspitzen zu vermeiden. Die Temperaturmesseinrichtung reagiert also mit einer bestimmten ersten Zeitkonstante auf eine zeitliche Änderung des elektrischen Stroms und damit auch der Temperaturdifferenz, wobei die erste Zeitkonstante größer sein kann als 0,5s, 1s, 2s, 5s oder sogar 10s. Die Erfindung ist jedoch hinsichtlich der Zeitkonstante der Temperaturmesseinrichtung nicht auf die vorstehend genannten Beispielwerte beschränkt, sondern grundsätzlich auch mit anderen Zeitkonstanten realisierbar.

Zur Verbesserung der zeitlichen Dynamik der Strommessung besteht im Rahmen der Erfindung auch die Möglichkeit, dass anstelle oder zusätzlich zu dem Absolutwert der gemessenen Temperaturdifferenz die zeitliche Änderung der gemessenen Temperaturdifferenz ausgewertet wird, so dass beispielsweise bereits nach 0,3-0,5s eine Aussage über den Strom getroffen werden kann. Diese Auswertung der zeitlichen Änderung der gemessenen Temperaturdifferenz eignet sich gut für eine Kurzschlussüberwachung in einem Stromkreis.

Ferner ist zu erwähnen, dass die Temperaturmesseinrichtung in dem bevorzugten Ausführungsbeispiel baulich in das elektronische Bauelement integriert ist. Hierzu kann die Temperaturmesseinrichtung beispielsweise eine Leiterplatte aufweisen, die an dem Anschlussteil und/oder an dem Widerstandselement befestigt ist, wobei die Leiterplatte die Thermosäulen trägt. Es besteht jedoch alternativ auch die Möglichkeit, dass die Thermosäulen direkt auf die Oberfläche des Bauelements aufgebracht sind, wobei die Thermosäulen elektrisch von dem Bauelement getrennt sind.

Darüber hinaus besteht im Rahmen der Erfindung auch die Möglichkeit, dass die Temperaturmesseinrichtung zusätzlich zu der Thermosäule auch eine Auswertungseinheit aufweist, die aus der gemessenen Temperaturdifferenz den elektrischen Strom ermittelt, der durch das elektronische Bauelement fließt. Diese Auswertungseinheit kann beispielsweise als ASIC realisiert sein oder in sonstiger Weise.

In einem Ausführungsbeispiel der Erfindung weist das elektronische Bauelement neben der Temperaturmesseinrichtung zusätzlich ein steuerbares Schaltelement auf, wobei das Schaltelement mit der Temperaturmesseinrichtung verbunden ist und in Abhängigkeit von der gemessenen Temperaturdifferenz schaltet. In dem bevorzugten Ausführungsbeispiel trennt das Schaltelement einen Stromkreis, wenn die gemessenen Temperaturdifferenz anzeigt, dass der durch den Stromsensor fließende elektrische Strom einen vorgegebenen Maximalwert überschreitet. Das Schaltelement schließt dann wieder den Stromkreis, wenn die von der Temperaturmesseinrichtung gemessene Temperaturdifferenz einen vorgegebenen Minimalwert unterschreitet. Hierbei kann eine Schalthysterese vorgesehen sein, indem der Maximalwert größer ist als der Minimalwert. Das Rücksetzen des Schaltelements kann jedoch auch von Hand erfolgen.

Es wurde bereits eingangs erwähnt, dass sich der durch den Stromsensor fließende elektrische Strom auch durch eine Spannungsmessung gemäß der bekannten Vierleitertechnik messen lässt. In einem bevorzugten Ausführungsbeispiel ist deshalb vorgesehen, dass zusätzlich eine Spannungsmesseinheit vorgesehen ist, welche die elektrische Spannung misst, die über dem Widerstandselement abfällt, um daraus den elektrischen Strom ableiten zu können. Auf diese Weise erfolgt die Strommessung durch zwei verschiedene Messprinzipien, nämlich zum einen durch eine Messung der Temperaturdifferenz zwischen dem Widerstandselement und den angrenzenden Anschlussteilen und zum anderen durch eine Spannungsmessung entsprechend der bekannten Vierleitertechnik. Dies bietet den Vorteil einer Redundanz bei der Strommessung.

Die Spannungsmesseinheit zur Messung der über dem Widerstandselement abfallenden elektrischen Spannung ist vorzugsweise baulich in das elektronische Bauelement integriert, so dass das Bauelement zusammen mit der Spannungsmesseinheit und/oder der Temperaturmesseinrichtung ein Strommessmodul bildet. Hierzu kann die Spannungsmesseinheit eine Leiterplatte aufweisen, die an dem Anschlussteil und/oder an dem Widerstandselement befestigt ist, wobei die Leiterplatte beispielsweise ein ASIC aufweisen kann, wie es in der eingangs erwähnten Patentanmeldung EP 1 253 430 A1 oder in EP 1 363 131 A1 beschrieben ist. Darüber hinaus weist die Spannungsmesseinheit zwei Spannungsabgriffe auf, die elektrisch mit den beiden Anschlussteilen verbunden sind, um die über dem Widerstandselement abfallende Spannung zu messen.

In dem bevorzugten Ausführungsbeispiel der Erfindung sind die Spannungsmesseinheit einerseits und die Temperaturmesseinrichtung andererseits auf gegenüberliegenden Seiten des elektronischen Bauelements angeordnet. Die Temperaturmesseinrichtung mit der Thermosäule befindet sich hierbei vorzugsweise auf der Unterseite des Stromsensors, d.h. auf der Montageseite, auf der der Stromsensor entsprechend der Oberflächenmontagetechnik (SMD: Surface Mounted Device) auf einer Leiterplatte angebracht werden kann. Die Spannungsmesseinheit befindet sich dagegen vorzugsweise auf der Oberseite des Stromsensors, d.h. auf der Seite, die der Montageseite gegenüberliegt.

Weiterhin ist zu erwähnen, dass die Strommessung gemäß der Vierleitertechnik zeitlich wesentlich dynamischer ist als die Strommessung durch eine Messung der Temperaturdifferenz zwischen dem Widerstandselement und den angrenzenden Anschlussteilen. Die Spannungsmesseinheit reagiert also mit einer bestimmten zweiten Zeitkonstante auf eine zeitliche Änderung des durch das elektronische Bauelement fließenden elektrischen Stroms, wobei diese zweite Zeitkonstante kleiner ist als die erste Zeitkonstante der Temperaturmesseinrichtung. Beispielsweise kann die zweite Zeitkonstante der Spannungsmesseinheit kleiner sein als 100ms, 50ms, 20ms oder 10ms.

In einer vorteilhaften Weiterbildung der Erfindung wird die von der Thermosäule erzeugte Thermospannung nicht nur als Messgröße ausgewertet, sondern auch zur Stromversorgung genutzt. Bei dieser Weiterbildung der Erfindung ist eine Stromversorgungseinheit vorgesehen, welche die Temperaturmesseinrichtung, die Spannungsmesseinheit, die Auswertungseinheit und/oder das steuerbare Schaltelement mit dem zum Betrieb erforderlichen Strom versorgt, wobei die Stromversorgungseinheit von der Thermosäule gespeist wird, so dass keine externe Stromversorgung benötigt wird. Zur Erreichung einer ausreichend hohen Versorgungsspannung kann die Thermosäule mehr als 20, 50, 100, 200, 500 oder sogar mehr als 1000 Thermoelemente aufweisen und eine Ausgangsspannung von mehr als 50mV, 100mV oder sogar mehr als 200mV zur Verfügung stellen.

Allgemein umfasst die Erfindung auch den Grundgedanken einer redundanten Strommessung mittels eines Messwerterfassungssystems, wobei das Messwerterfassungssystem den durch das Bauelement fließenden elektrischen Strom nach unterschiedlichen physikalischen Messprinzipien misst, wie beispielsweise durch eine Vierleitermessung von Strom und Spannung einerseits und durch eine Messung der Temperaturdifferenz zwischen dem Widerstandselement und den Anschlussteilen andererseits. Dieser Grundgedanke einer redundanten Strommessung ist jedoch auch mit anderen Messprinzipien realisierbar.

In dem bevorzugten Ausführungsbeispiel sind die Anschlussteile und/oder das Widerstandselement plattenförmig, insbesondere in ebener oder gebogener Form. Alternativ besteht jedoch auch die Möglichkeit, dass das Bauelement aus einem gewölbten, runden oder anders geformten Material oder aus Rohrstücken geformt ist. Darüber hinaus sind die Anschlussteile vorzugsweise mit dem Widerstandselement verschweißt, insbesondere durch einen Elektronenstrahlverschweißung. Die einzelnen Strommesswiderstände können also aus einem sogenannten Tri-Band abgeschnitten werden, wobei das Tri-Band aus zwei außenliegenden Kupferstreifen bestehen kann, die mit einem in der Mitte liegenden Manganin-Streifen elektronenstrahlverschweißt sind. Diese Art der Herstellung des Stromsensors aus einem Verbundmaterial ist äußerst kostengünstig, wie in EP 0 605 800 A1 ausführlich erläutert wird.

Weiterhin ist zu erwähnen, dass das Leitermaterial der Anschlussteile einen kleineren spezifischen elektrischen Widerstand aufweist als das Widerstandsmaterial des Widerstandselements. Beispielsweise kann das Leitermaterial der Anschlussteile einen spezifischen elektrischen Widerstand von weniger als 5·10⁻⁷Ωm, 2·10⁻⁷Ωm, 1·10⁻⁷Ωm, 5·10⁻⁸Ωm oder sogar 2·10⁻⁸Ωm aufweisen. Das Widerstandsmaterial des Widerstandselements ist dagegen vorzugsweise niederohmig, insbesondere mit einem spezifischen elektrischen Widerstand von weniger als 50·10⁻⁷Ωm, 20·10⁻⁷Ωm, 10·10⁻⁷Ωm oder sogar 5·10⁻⁷Ωm. Das Widerstandsmaterial ist jedoch hochohmiger als das Leitermaterial, insbesondere mit einem spezifischen Widerstand von mehr als 10·10⁻⁸Ωm, 20·10⁻⁸Ωm, 50·10⁻⁸Ωm, 10·10⁻⁸Ωm, 10·10⁻⁷Ωm, 20·10⁻⁷Ωm.

Bei dem Widerstandsmaterial des Widerstandselements handelt es sich vorzugsweise um eine Widerstandslegierung, wie beispielsweise Kupfer-Mangan-Nickel, insbesondere Cu84Ni4Mn12 (Manganin®), Nickel-Chrom, Nickel-Chrom-Aluminium-Silizium, Kupfer-Nickel, Nickel-Eisen, Kupfer-Nickel-Mangan oder Kupfer-Nickel.

Ferner ist zu erwähnen, dass das Widerstandsmaterial des Widerstandselements vorzugsweise eine hohe Temperaturkonstanz bezüglich seines spezifischen elektrischen Widerstands aufweist. Beispielsweise kann der lineare Temperaturkoeffizient des Widerstandsmaterials kleiner sein als 1·10⁻³K⁻¹, 0,5·10⁻³K⁻¹, 0,2·10⁻³K⁻¹, 0, 1·10⁻³K⁻¹, 0,05·10⁻³K⁻¹ oder 0,03·10⁻³K⁻¹.

Darüber hinaus ist zu erwähnen, dass das Widerstandsmaterial des Widerstandselements in der thermoelektrischen Spannungsreihe eine andere Thermokraft aufweisen kann als das Leitermaterial der Anschlussteile, damit die Messung durch Thermoelemente eine entsprechende Thermospannung erzeugt.

Ferner weist das Widerstandsmaterial des Widerstandselements in der Regel eine kleinere Wärmeleitfähigkeit auf als das Leitermaterial der Anschlussteile, so dass die Temperatur in den Anschlussteilen nach außen hin langsamer abfällt als in dem Widerstandselement selbst. Beispielsweise kann die Wärmeleitfähigkeit des Widerstandsmaterials im Bereich von 20Wm⁻¹K⁻¹ bis 500Wm⁻¹K⁻¹ liegen.

Andere vorteilhafte Weiterbildungen der Erfindung sind in den Unteransprüchen gekennzeichnet oder werden nachstehend zusammen mit der Beschreibung der bevorzugten Ausführungsbeispiele der Erfindung anhand der Figuren näher erläutert. Es zeigen:
- Figur 1A: eine Querschnittsansicht eines erfindungsgemäßen Strommessmoduls,
- Figur 1B: eine Unteransicht des Strommessmoduls gemäß Figur 1A von der Montageseite,
- Figur 1C: den Temperaturverlauf in dem Strommessmodul gemäß den Figuren 1A und 1B in Stromrichtung,
- Figur 2: eine Unteransicht einer Abwandlung des Strommessmoduls aus den Figuren 1A-1C mit zwei getrennt kontaktierbaren Thermosäulen,
- Figur 3: eine Abwandlung des Strommessmoduls gemäß Figur 2 mit zwei elektrisch in der Reihe geschalteten Thermosäulen,
- Figur 4: den Verlauf der Thermospannung in Abhängigkeit von dem durch das Strommessmodul fließenden elektrischen Strom,
- Figur 5: die Änderungsgeschwindigkeit der Ausgangsspannung bei verschiedenen elektrischen Strömen, sowie
- Figur 6: ein vereinfachtes Prinzipschaltbild eines erfindungsgemäßen Strommessmoduls.

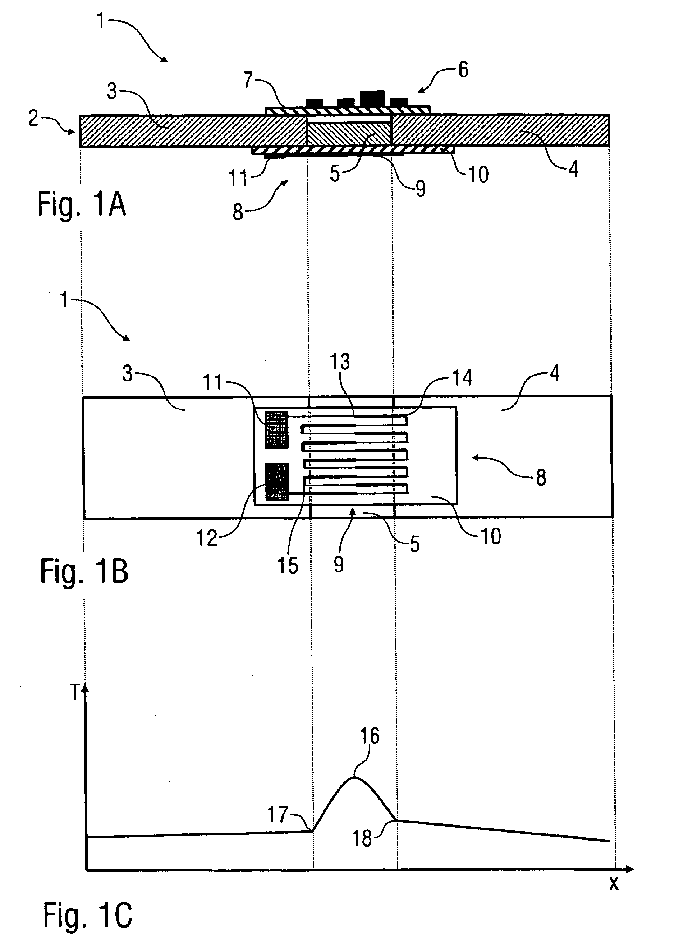

Die Figuren 1A und 1B zeigen ein erfindungsgemäßes Strommessmodul 1 zur Messung eines elektrischen Stroms in einem Stromkreis, beispielsweise in einem Kraftfahrzeugbordnetz.

Das Strommessmodul 1 weist einen Strommesswiderstand 2 auf, der aus zwei plattenförmigen Anschlussteilen 3, 4 aus Kupfer oder einer Kupferlegierung und einem ebenfalls plattenförmigen Widerstandselement 5 aus Manganin® besteht, wobei der Strommesswiderstand 2 aus einem Verbundmaterialband ("Tri-Band") abgeschnitten ist, das aus zwei Kupferstreifen besteht, die mit einem in der Mitte angeordneten Mangangin-Streifen elektronenstrahlverschweißt sind, was an sich aus der bereits eingangs erwähnten Patentanmeldung EP 0 605 800 A1 bekannt ist.

An der Oberseite des Strommessmoduls 1 befindet sich eine Spannungsmesseinheit 6, die im Wesentlichen aus einer Leiterplatte 7 und elektronischen Bauelementen (z.B. einem ASIC) auf der Leiterplatte 7 besteht, wobei die Spannungsmesseinheit 6 elektrisch mit den beiden Anschlussteilen 3, 4 verbunden ist und die Spannung misst, die über dem Widerstandselement 5 abfällt, um daraus entsprechend dem Ohmschen Gesetz den elektrischen Strom berechnen zu können, der durch den Strommesswiderstand 2 fließt. Die Spannungsmesseinheit 6 kann hierbei in herkömmlicher Weise ausgebildet sein, wie beispielsweise in der eingangs erwähnten Patentanmeldung EP 1 253 430 A1 beschrieben ist.

An der unten liegenden Montageseite des Strommessmoduls 1 ist dagegen eine Temperaturmesseinrichtung 8 angebracht, die eine Thermosäule 9 aufweist, wobei die Thermosäule 9 auf einer Leiterplatte 10 angeordnet ist und zwei Anschlusskontakte 11, 12 aufweist, an denen eine Thermospannung gemessen werden kann, welche die Temperaturdifferenz zwischen dem Widerstandselement 5 einerseits und den Anschlussteilen 3, 4 andererseits wiedergibt. Hierzu weist die Thermosäule 9 heiße Kontaktstellen 13 und kalte Kontaktstellen 14, 15 auf, wobei die heißen Kontaktstellen 13 das Widerstandselement 5 durch die Leiterplatte 10 hindurch thermisch kontaktieren, wohingegen die kalten Kontaktstellen 14, 15 durch die Leiterplatte 10 hindurch abwechselnd das Anschlussteil 3 und das Anschlussteil 4 thermisch kontaktieren. Die über den Anschlusskontakten 11, 12 abfallende Thermospannung gibt also die Temperaturdifferenz zwischen dem Widerstandselement 5 einerseits und den Anschlussteilen 3, 4 andererseits wieder, wobei diese Temperaturdifferenz ein Maß für den elektrischen Strom bildet, der durch den Strommesswiderstand 2 fließt.

So zeigt Figur 1C den Temperaturverlauf in dem Strommesswiderstand 2 entlang der Stromrichtung. Daraus ist ersichtlich, dass sich in dem Widerstandselement 5 ein sogenannten "hot spot" 16 mit einer besonders großen Temperatur T ausbildet, während sich die Temperatur T in beiden Richtungen zu den Anschlussteilen 3, 4 verringert. Weiterhin ist aus der Zeichnung ersichtlich, dass der Temperaturverlauf an den Übergängen von dem Widerstandselement 5 zu den Anschlussteilen 3, 4 zwei Knickstellen 17, 18 aufweist, die daher rühren, dass das Leitermaterial der Anschlussteile 3, 4 eine größere Wärmeleitfähigkeit aufweist als das Widerstandsmaterial des Widerstandselements 5.

Vorteilhaft an dem Strommessmodul 1 ist die Tatsache, dass die Strommessung redundant erfolgt, nämlich zum einen durch die Spannungsmesseinheit 6 und zum anderen durch die Temperaturmesseinrichtung 8.

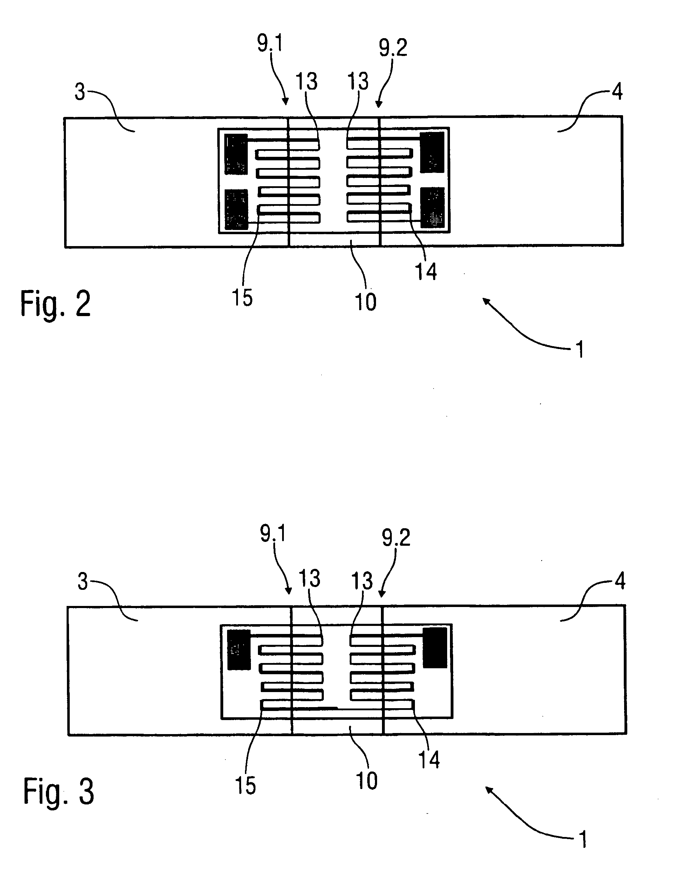

Figur 2 zeigt eine Bodenansicht einer Abwandlung des Strommessmoduls 1 gemäß den Figuren 1A-1C, so dass zur Vermeidung von Wiederholungen auf die vorstehende Beschreibung verwiesen wird, wobei für entsprechende Einzelheiten dieselben Bezugszeichen verwendet werden.

Eine Besonderheit dieses Ausführungsbeispiels besteht darin, dass die Temperaturmesseinrichtung 8 zwei Thermosäulen 9.1, 9.2 aufweist, die galvanisch voneinander getrennt sind. Die Thermosäule 9.1 misst hierbei die Temperaturdifferenz zwischen dem Widerstandselement 5 und dem Anschlussteil 3, während die Thermosäule 9.2 die Temperaturdifferenz zwischen dem Widerstandselement 5 und dem Anschlussteil 4 misst.

Die Summe der beiden Thermospannungen, die von den beiden Thermosäulen 9.1, 9.2 gemessen werden, bildet hierbei ein Maß für die Größe des elektrischen Stroms, der durch den Strommesswiderstand 2 fließt.

Darüber hinaus verursacht der Peltier-Effekt eine asymmetrische Temperaturverteilung in dem Strommesswiderstand 2, wie auch ansatzweise aus Figur 1C ersichtlich ist. Aus einem Vergleich der beiden Thermospannungen, die von den beiden Thermosäulen 9.1, 9.2 generiert werden, lässt sich dann auch die Stromrichtung ermitteln.

Figur 3 zeigt eine Abwandlung des Ausführungsbeispiels gemäß Figur 2, so dass zur Vermeidung von Wiederholungen auf die vorstehende Beschreibung verwiesen wird, wobei für entsprechende Einzelheiten dieselben Bezugszeichen verwendet werden.

Im Gegensatz zu dem Ausführungsbeispiel gemäß Figur 2 sind die beiden Thermosäulen 9.1, 9.2 hierbei elektrisch in Reihe geschaltet.

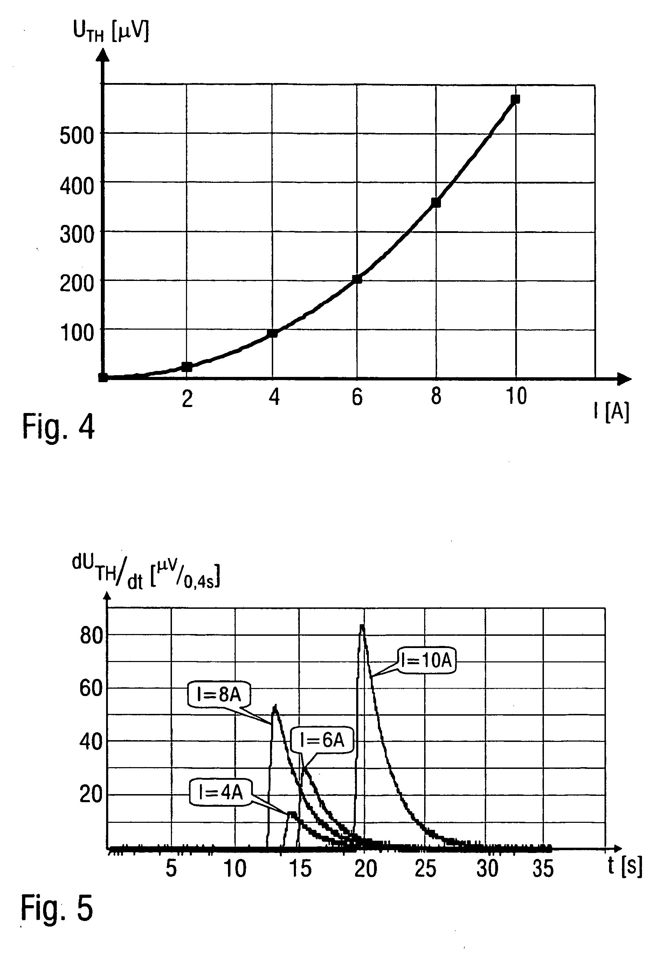

Figur 4 zeigt exemplarisch den Verlauf einer Thermospannung U_{TH} in Abhängigkeit von einem elektrischen Strom I, der durch den Strommesswiderstand 2 fließt.

Figur 5 zeigt exemplarisch zeitliche Verläufe der Änderungsgeschwindigkeit dU_{TH}/dt der Thermospannung in Abhängigkeit von der Zeit nach einer Stromänderung.

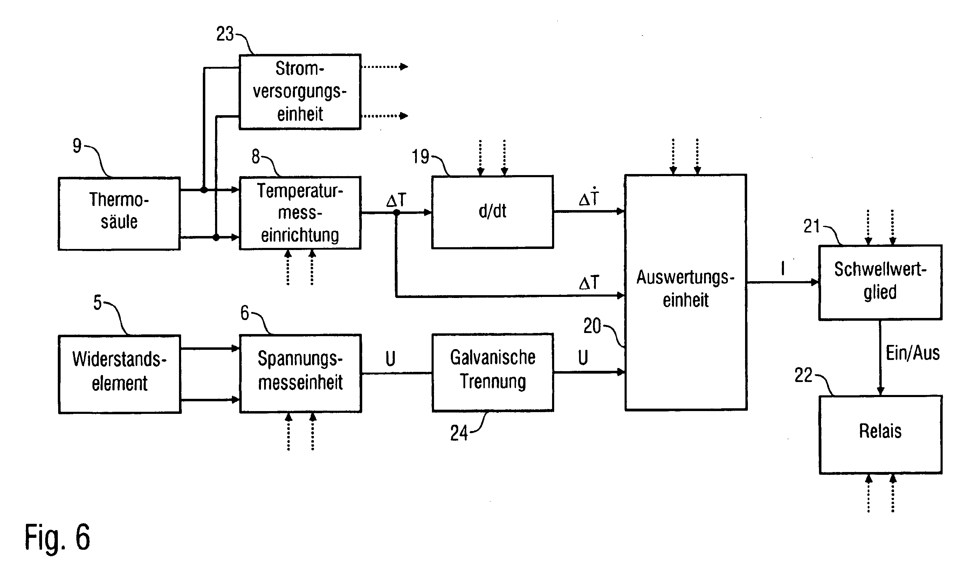

Schließlich zeigt Figur 6 ein vereinfachtes Schaltbild des Strommessmoduls 1 gemäß den Figuren 1A-1C, so dass zur Vermeidung von Wiederholungen auf die vorstehende Beschreibung verwiesen wird, wobei für entsprechende Einzelheiten dieselben Bezugszeichen verwendet werden.

Aus diesem Schaltbild ist zusätzlich noch zu erkennen, dass ein Differenzierer 19 vorgesehen ist, der die zeitliche Ableitung ΔṪ der von der Temperaturmesseinrichtung 8 gemessenen Temperaturdifferenz ΔT bildet.

Weiterhin ist eine Auswertungseinheit 20 vorgesehen, die den elektrischen Strom I ermittelt, der durch den Strommesswiderstand 2 fließt. Hierbei berücksichtigt die Auswertungseinheit 20 zum einen die Temperaturdifferenz ΔT und die zeitliche Ableitung ΔṪ der Temperaturdifferenz ΔT und zum anderen die elektrische Spannung U, die über dem Widerstandselement 5 abfällt und von der Spannungsmesseinheit 6 gemessen wird.

Der auf diese Weise ermittelte Messwert des elektrischen Stroms I wird dann an ein Schwellwertglied 21 weitergeleitet, wobei das Schwellwertglied 21 ein Relais 22 oder ein sonstiges Schaltelement ansteuert. Falls der gemessene elektrische Strom I einen vorgegebenen Maximalwert I_{MAX} überschreitet, so steuert das Schwellwertglied 21 das Relais 22 so an, dass der Stromkreis getrennt wird, um ein weiteres Ansteigen des Stroms zu verhindern. Wenn der elektrische Strom I dann wieder unter einen vorgegebenen Minimalwert I_{MIN} gefallen ist, so steuert das Schwellwertglied 21 das Relais 22 dazu an, dass der Stromkreis wieder geschlossen wird. Das Schwellwertglied 21 weist hierbei eine Schalthysterese auf, um zu häufiges Schalten zu vermeiden.

Schließlich ist noch zu erwähnen, dass das Strommessmodul 1 eine Stromversorgungseinheit 23 aufweist, die von der Thermosäule 9 gespeist wird und die Temperaturmesseinrichtung 8, den Differenzierer 19, die Auswertungseinheit 20, das Schwellwertglied 21, das Relais 22 und die Spannungsmesseinheit 6 mit dem zum Betrieb erforderlichen elektrischen Strom versorgt, so dass das Strommessmodul 1 keine externe Stromversorgung benötigt.

Weiterhin ist zu erwähnen, dass zwischen der Auswertungseinheit 20 und der Spannungsmesseinheit 6 eine galvanische Trennung 24 vorgesehen ist.

### Bezugszeichenliste:

- 1: Strommessmodul
- 2: Strommesswiderstand
- 3: Anschlussteil
- 4: Anschlussteil
- 5: Widerstandselement
- 6: Spannungsmesseinheit
- 7: Leiterplatte
- 8: Temperaturmesseinrichtung
- 9: Thermosäule
- 10: Leiterplatte
- 11: Anschlusskontakt
- 12: Anschlusskontakt
- 13: Heiße Kontaktstelle
- 14: Kalte Kontaktstelle
- 15: Kalte Kontaktstelle
- 16: Hot Spot
- 17: Knickstelle des Temperaturverlaufs
- 18: Knickstelle des Temperaturverlaufs
- 19: Differenzierer
- 20: Auswertungseinheit
- 21: Schwellwertglied
- 22: Relais
- 23: Stromversorgungseinheit
- 24: Galvanische Trennung

## Patentansprüche

1. Elektronisches Bauelement (1), nämlich Stromsensor, mit
a) einem Widerstandselement (5) aus einem Widerstandsmaterial,
b) einem ersten Anschlussteil (3) aus einem Leitermaterial zur Einleitung eines elektrischen Stroms (I) in das Widerstandselement (5), und
c) einem zweiten Anschlussteil (4) aus einem Leitermaterial zum Abführen des elektrischen Stroms (I) von dem Widerstandselement (5),
d) wobei das Leitermaterial der Anschlussteile (3, 4) einen kleineren spezifischen elektrischen Widerstand aufweist als das Widerstandsmaterial des Widerstandselements (5), sowie mit
e) einem Messwerterfassungssystem, das zur Messung des durch das elektronische Bauelement (1) fließenden elektrischen Stroms (I) eingerichtet ist, wobei das Messwerterfassungssystem baulich in das elektronische Bauelement (1) integriert ist,
**dadurch gekennzeichnet,**
f) dass das Messwerterfassungssystem eingerichtet ist, um den durch das elektronische Bauelement (1) fließenden elektrischen Strom (I) nach mehreren unterschiedlichen physikalischen Messprinzipien zu messen, nämlich
g) zum Einen durch eine Vierleitermessung, wobei der zu messende elektrische Strom über zwei Anschlusskontakte durch das Widerstandselement hindurchgeleitet wird, während über zwei weitere Anschlusskontakte die elektrische Spannung gemessen wird, die über dem Widerstandselement abfällt, und
h) zum Anderen durch eine Messung mindestens einer Temperaturdifferenz (ΔT) zwischen dem Widerstandselement (5) einerseits und einem der beiden Anschlussteile (3, 4) andererseits.

2. Elektronisches Bauelement nach Anspruch 1, **gekennzeichnet durch** eine Temperaturmesseinrichtung (8) zur Messung der Temperaturdifferenz (ΔT) zwischen dem Widerstandselement (5) einerseits und mindestens einem der beiden Anschlussteile (3, 4) andererseits.

3. Elektronisches Bauelement (1) nach Anspruch 2, **dadurch gekennzeichnet, dass** die Temperaturmesseinrichtung (8) mindestens ein Thermoelement mit einer heißen Kontaktstelle (13) und einer kalten Kontaktstelle aufweist (14, 15), wobei die heiße Kontaktstelle (13) das Widerstandselement (5) thermisch kontaktiert, während die kalte Kontaktstelle (14, 15) eines der beiden Anschlussteile (3, 4) thermisch kontaktiert.

4. Elektronisches Bauelement (1) nach Anspruch 3,
**dadurch gekennzeichnet,**
a) **dass** die Temperaturmesseinrichtung (8) eine Thermosäule (9, 9.1, 9.2) mit mehreren Thermoelementen aufweist, die elektrisch hintereinander geschaltet sind, und
b) **dass** die heißen Kontaktstellen (13) der Thermoelemente jeweils das Widerstandselement (5) thermisch kontaktieren, und
c) **dass** die kalten Kontaktstellen (14, 15) der Thermoelemente abwechselnd das erste Anschlussteil (3) und das zweite Anschlussteil (4) thermisch kontaktieren.

5. Elektronisches Bauelement (1) nach Anspruch 3,
**dadurch gekennzeichnet,**
a) **dass** die Temperaturmesseinrichtung (8) eine erste Thermosäule (9.1) und eine zweite Thermosäule (9.2) aufweist,
b) **dass** die heißen Kontaktstellen (13) der beiden Thermosäulen (9.1, 9.2) jeweils das Widerstandselement (5) thermisch kontaktieren,
c) **dass** die kalten Kontaktstellen (15) der ersten Thermosäule (9.1) das erste Anschlussteil (3) thermisch kontaktieren,
d) **dass** die kalten Kontaktstellen (14) der zweiten Thermosäule (9.2) das zweite Anschlussteil (4) thermisch kontaktieren.

6. Elektronisches Bauelement (1) nach Anspruch 5,
**dadurch gekennzeichnet,**
a) **dass** die beiden Thermosäulen (9.1, 9.2) auf dem Bauelement (1) zu einer elektrischen Reihenschaltung zusammengeschaltet und elektrisch mit zwei gemeinsamen Anschlusskontakten auf dem Bauelement (1) verbunden sind, oder
b) **dass** die beiden Thermosäulen (9.1, 9.2) auf dem Bauelement (1) elektrisch voneinander getrennt und elektrisch getrennt voneinander mit jeweils zwei Anschlusskontakten elektrisch verbunden sind, um die Thermospannungen der beiden Thermosäulen getrennt messen zu können.

7. Elektronisches Bauelement (1) nach einem der Ansprüche 4 bis 5, **dadurch gekennzeichnet,**
a) **dass** die heißen Kontaktstellen (13) der Thermoelemente auf dem Widerstandselement (5) in einer Reihe nebeneinander liegen, wobei die Reihe der heißen Kontaktstellen (13) im Wesentlichen quer zur Stromrichtung verläuft, oder
b) **dass** die heißen Kontaktstellen (13) der Thermoelemente auf dem Widerstandselement (5) verteilt angeordnet sind.

8. Elektronisches Bauelement (1) nach einem der vorhergehenden Ansprüche, **dadurch gekennzeichnet,**
a) **dass** die Temperaturmesseinrichtung (8) mit einer bestimmten ersten Zeitkonstante auf eine zeitliche Änderung der Temperaturdifferenz (ΔT) reagiert, wobei die erste Zeitkonstante größer ist als 0,5s, 1s, 2s, 5s oder 10s, und
b) **dass** die Temperaturmesseinrichtung (8) die zeitliche Änderung der gemessenen Temperaturdifferenz (ΔT) ermittelt und auswertet, und
c) **dass** die Temperaturmesseinrichtung (8) galvanisch von den Anschlussteilen (3, 4) und dem Widerstandselement (5) getrennt ist, und
d) **dass** die Temperaturmesseinrichtung (8) baulich in das elektronische Bauelement (1) integriert ist, und
e) **dass** die Temperaturmesseinrichtung (8) eine Auswertungseinheit (20) aufweist, die aus der gemessenen Temperaturdifferenz (ΔT) den elektrischen Strom (I) oder die elektrische Leistung ermittelt, der durch das elektronische Bauelement (1) fließt, und
f) **dass** die Temperaturmesseinrichtung (8) eine Leiterplatte (10) aufweist, die an den Anschlussteilen (3, 4) und/oder an dem Widerstandselement (5) befestigt ist.

9. Elektronisches Bauelement (1) nach einem der Ansprüche 2 bis 8, **gekennzeichnet durch** ein steuerbares Schaltelement (22), wobei das Schaltelement (22) mit der Temperaturmesseinrichtung (8) verbunden ist und in Abhängigkeit von der gemessenen Temperaturdifferenz (ΔT) schaltet.

10. Elektronisches Bauelement (1) nach Anspruch 9,
**dadurch gekennzeichnet,**
a) **dass** das steuerbare Schaltelement (22) ein Relais ist, insbesondere (22) ein bistabiles Relais, und
b) **dass** das Schaltelement (22) mit dem Widerstandselement (5) elektrisch in Reihe geschaltet ist, und
c) **dass** das Schaltelement (22) öffnet, wenn die von der Temperaturmesseinrichtung (8) gemessene Temperaturdifferenz (ΔT) einen vorgegebenen Maximalwert überschreitet und
d) **dass** das Schaltelement (22) schließt, wenn die von der Temperaturmesseinrichtung (8) gemessene Temperaturdifferenz (ΔT) einen vorgegebenen Minimalwert unterschreitet, und
e) **dass** das Schaltelement (22) baulich in das elektronische Bauelement (1) integriert ist.

11. Elektronisches Bauelement (1) nach einem der vorhergehenden Ansprüche, **gekennzeichnet durch** eine Spannungsmesseinheit (6), welche die elektrische Spannung misst, die über dem Widerstandselement (5) abfällt.

12. Elektronisches Bauelement (1) nach Anspruch 11, **dadurch gekennzeichnet,**
a) **dass** die Spannungsmesseinheit (6) baulich in das elektronische Bauelement (1) integriert ist, und
b) **dass** die Spannungsmesseinheit (6) eine Leiterplatte (7) aufweist, die an den Anschlussteilen (3, 4) und/oder an dem Widerstandselement (5) befestigt ist, und
c) **dass** die Spannungsmesseinheit (6) zwei Spannungsabgriffe aufweist, die elektrisch mit den beiden Anschlussteilen (3, 4) verbunden sind, um die über dem Widerstandselement (5) abfallende Spannung zu messen, und
d) **dass** die Spannungsmesseinheit (6) einerseits und die Temperaturmesseinrichtung (8) andererseits auf gegenüberliegenden Seiten des elektronischen Bauelements (1) angeordnet sind, und
e) **dass** die Spannungsmesseinheit (6) mit einer bestimmten zweiten Zeitkonstante auf eine zeitliche Änderung des durch das elektronische Bauelement (1) fließenden elektrischen Stroms (I) reagiert, wobei die zweite Zeitkonstante kleiner ist als die erste Zeitkonstante der Temperaturmesseinrichtung (8) und/oder kleiner als 100ms, 50ms, 20ms oder 10ms.

13. Elektronisches Bauelement (1) nach einem der Ansprüche 2 bis 12, **dadurch gekennzeichnet,**
a) **dass** eine Stromversorgungseinheit (23) vorgesehen ist, welche die Temperaturmesseinrichtung (8) und/oder die Spannungsmesseinheit (6) und/oder das steuerbare Schaltelement (22) mit dem zum Betrieb erforderlichen elektrischen Strom versorgt, und
b) **dass** die Stromversorgungseinheit (23) von der Thermosäule (9, 9.1, 9.2) gespeist wird, und
c) **dass** die Thermosäule (9, 9.1, 9.2) mehr als 20, 50, 100, 200, 500 oder mehr als 1000 Thermoelemente aufweist, und
d) **dass** die Thermosäule (9, 9.1, 9.2) im bestromten Zustand des elektronischen Bauelements (1) eine Ausgangsspannung von mehr als 50mV, 100mV oder mehr als 200mV zur Verfügung stellt, und
e) **dass** das elektronische Bauelement (1) aufgrund der integrierten Stromversorgungseinheit (23) keine externe Stromversorgung benötigt.

14. Elektronisches Bauelement (1) nach einem der vorhergehenden Ansprüche, **dadurch gekennzeichnet,**
a) **dass** die Anschlussteile (3, 4) und/oder das Widerstandselement (5) plattenförmig sind, insbesondere in ebener oder gebogener Form, und
b) **dass** die Anschlussteile (3, 4) mit dem Widerstandselement (5) verschweißt sind, insbesondere durch eine Elektronenstrahlverschweißung, und
c) **dass** das Leitermaterial der Anschlussteile (3, 4) Kupfer oder eine Kupferlegierung ist, und
d) **dass** das Leitermaterial der Anschlussteile (3, 4) einen spezifischen elektrischen Widerstand von weniger als 5·10⁻⁷Ωm, 2·10⁻⁷Ωm, 1·10⁻⁷Ωm, 5·10⁻⁸Ωm oder 2·10⁻⁸Ωm aufweist, und
e) **dass** das Widerstandsmaterial des Widerstandselements (5) eine Widerstandslegierung ist, insbesondere Kupfer-Mangan-Nickel, insbesondere Cu84Ni4Mn12, Nickel-Chrom, Nickel-Chrom-Aluminium-Silizium, Kupfer-Nickel, Nickel-Eisen, Kupfer-Nickel-Mangan oder Kupfer-Nickel, und
f) **dass** das Widerstandsmaterial des Widerstandselements (5) niederohmig ist, insbesondere mit einem spezifischen elektrischen Widerstand von weniger als 50·10⁻⁷ Ωm, 20·10⁻⁷Ωm, 10·10⁻⁷Ωm oder 5·10⁻⁷Ωm, und
g) **dass** das Widerstandsmaterial des Widerstandselements (5) eine hohe Temperaturkonstanz bezüglich seines spezifischen elektrischen Widerstands aufweist, insbesondere mit einem linearen Temperaturkoeffizienten von weniger als 1·10⁻³K⁻¹, 0,5·10⁻³K⁻¹, 0,2·10⁻³K⁻¹, 0,1·10⁻³K⁻¹, 0,05·10⁻³K⁻¹ oder 0,03·10⁻³K⁻¹, und
h) **dass** das Widerstandsmaterial des Widerstandselements (5) in der thermoelektrischen Spannungsreihe eine andere Thermokraft aufweist als das Leitermaterial der Anschlussteile (3, 4), und
i) **dass** das Widerstandsmaterial des Widerstandselements (5) eine kleinere Wärmeleitfähigkeit aufweist als das Leitermaterial der Anschlussteile (3, 4), und/oder
j) **dass** die Wärmeleitfähigkeit des Widerstandsmaterials des Widerstandselements (5) kleiner ist als 100Wm⁻¹K⁻¹, 50Wm⁻¹K⁻¹ oder 25Wm⁻¹K⁻¹ und größer als 1Wm⁻¹K⁻¹, 2Wm⁻¹K⁻¹, 5Wm⁻¹K⁻¹, 10Wm⁻¹K⁻¹ oder 20Wm⁻¹K⁻¹, und
k) **dass** die Wärmeleitfähigkeit des Leitermaterials der Anschlussteile (3, 4) größer ist als 100Wm⁻¹K⁻¹, 200Wm⁻¹K⁻¹ oder 300Wm⁻¹K⁻¹ und kleiner als 2000Wm⁻¹K⁻¹, 1000Wm⁻¹K⁻¹ oder 500Wm⁻¹K⁻¹, und
l) **dass** das Widerstandsmaterial hochohmiger ist als das Leitermaterial, insbesondere mit einem spezifischen elektrischen Widerstand von mehr als 10·10⁻⁸Ωm, 20·10⁻⁸Ωm, 50·10⁻⁸Ωm, 10·10⁻⁷Ωm oder 20·10⁻⁷Ωm.

## Claims

1. An electronic component (1), namely a current sensor, with
a) a resistance element (5) made of a resistance material,
b) a first connection part (3) made out of a conductor material for leading an electrical current (I) into the resistance element (5), and
c) a second connection part (4) made out of a conductor material for leading the electrical current (I) out of the resistance element (5),
d) wherein the conductor material of the connection part (3, 4) has a smaller specific electric resistance than the resistance material of the resistor element (5), as well as with
e) a measurement value recording system, which is set up to measure the electrical current (I) flowing through the electronic component (1), wherein the measurement acquisition system is constructionally integrated into the electronic component (1),
**characterized in that**
f) the measurement value recording system is set up to measure the electrical current (I) flowing through the electronic component (1) according to a number of different physical measuring principles, namely
g) on the one hand by means of a four wire measurement, wherein the electrical current to be measured is passed over two contacts through the resistance element while the electrical voltage is measured via two further contacts, which drops over the resistance element, and
h) on the other hand through measurement of at least a temperature difference (ΔT) between the resistance element (5) on the one hand and one of the two connection parts (3, 4) on the other.

2. The electronic component according to Claim 1, **characterized by** a temperature measuring device (8) for measurement of the temperature difference (ΔT) between the resistance element (5) on the one hand and at least one of both connection parts (3, 4) on the other hand.

3. The electronic component (1) according to Claim 2, **characterized in that** the temperature measuring device (8) has at least one thermal element with a hot contact point (13) and a cold contact point (14, 15), wherein the hot contact point (13) thermally contacts the resistance element (5) while the cold contact point (14, 15) thermally contacts one of the two connection parts (3, 4).

4. The electronic component (1) according to Claim 3, **characterized in that**
a) the temperature measuring device (8) has a thermopile (9, 9.1, 9.2) with multiple thermoelements, which are electrically switched the one behind the other, and
b) the hot contact points (13) of the thermoelements are each thermally in contact with the resistance element (5), and
c) the cold contact points (14, 15) of the thermal elements are alternately thermally in contact with the first connection part (3) and the second connection part (4).

5. The electronic component (1) according to Claim 3, **characterized in that**
a) the temperature measuring device (8) has a first thermopile (9.1) and a second thermopile (9.2),
b) the hot contact points (13) of both thermopiles (9.1, 9.2) are each thermally in contact with the resistance element (5),
c) the cold contact points (15) of the first thermopile (9.1) are thermally in contact with the first connection part (3),
d) the cold contact points (14) of the second thermopile (9.2) are thermally in contact with the second connection part (4).

6. The electronic component (1) according to Claim 5, **characterized in that**
a) both thermopiles (9.1, 9.2) on the component (1) are switched together to form an electrical series connection and are electrically connected with two common contacts to the component (1), or
b) both thermopiles (9.1, 9.2) on the component (1) are electrically separated from each other and electrically separately connected respectively with two contacts in order to measure the thermoelectric voltages of both thermopiles separately.

7. The electronic component (1) according to any one of Claims 4 to 5, **characterized in that**
a) the hot contact points (13) of the thermoelements on the resistance elements (5) lie in a row side by side, wherein the row of the hot contact points (13) essentially runs transverse to the direction of the current, or
b) the hot contact points (13) of the thermoelements are arranged in such a way that they are distributed over the resistance element (5).

8. The electronic component (1) according to any one of the preceding claims, **characterized in that**
a) the temperature measuring device (8) reacts to a temporal change in the temperature difference (ΔT) according to a certain first time constant wherein the first time constant is greater than 0.5s, 1s, 2s, 5s or 10s, and
b) the temperature measuring device (8) determines and evaluates the temporal change in the measured temperature difference (ΔT), and
c) the temperature measuring device (8) is galvanically separated from the connection parts (3, 4) and the resistance element (5), and
d) the temperature measuring device (8) is constructionally integrated into the electronic component (1), and
e) the temperature measuring device (8) has an evaluation unit (20), which determines the electrical current (I) or the electrical output based on the measured temperature difference (ΔT) which flows through the electronic component (1), and
f) the temperature measuring device (8) has a printed circuit board (10), which is fastened to the connection parts (3, 4) and/or to the resistance element (5).

9. The electronic component (1) according to any one of Claims 2 to 8, **characterized by** a controllable switching element (22), wherein the switching element (22) is connected with the temperature measuring device (8) and is switched dependin on the measured temperature difference (ΔT).

10. The electronic component (1) according to Claim 9, **characterized in that**
a) the controllable switching element (22) is a relay, in particular (22) a bistable relay, and
b) the switching element (22) is electrically connected in series with the resistance element (5), and
c) the switching element (22) opens if the temperature difference (ΔT) measured by the temperature measuring device (8) exceeds a prescribed maximum value and
d) the switching element (22) closes if the temperature difference (ΔT) measured by the temperature measuring device (8) goes below a prescribed minimum value and
e) the switching element (22) is constructionally integrated into the electronic component (1).

11. The electronic component (1) according to any one of the preceding claims, **characterized by** a voltage measurement unit (6), which measures the electrical voltage which drops over the resistance element (5).

12. The electronic component (1) according to Claim 11, **characterized in that**
a) the voltage measurement unit (6) is constructionally integrated into the electronic component (1), and
b) the voltage measurement unit (6) has a printed circuit board (7), which is fastened to the connection parts (3, 4) and/or to the resistance element (5) and
c) the voltage measurement unit (6) has two voltage tapping points, which are connected electrically with both connection parts (3, 4) in order to measure the voltage, which drops over the resistance element (5), and
d) the voltage measurement unit (6) is arranged on the one side and the temperature measuring device (8) on the other side on opposing sides of the electronic component (1), and
e) the voltage measurement unit (6) reacts according to a certain second time constant to a temporal change of the electrical current (I) flowing through the electronic component (1), wherein the second time constant is smaller than the first time constant of the temperature measuring device (8) and/or less than 100ms, 50ms, 20ms or 10ms.

13. The electronic component (1) according to any one of Claims 2 to 12, **characterized in that**
a) a power supply unit (23) is provided, which supplies the temperature measuring device (8) and/or the voltage measurement unit (6) and/or the controllable switching element (22) with the electrical current required for operation, and
b) the power supply unit (23) is fed by the thermopile (9, 9.1, 9.2), and
c) the thermopile (9, 9.1, 9.2) has more than 20, 50, 100, 200, 500 or more than 1000 thermoelements, and
d) the thermopile (9, 9.1, 9.2) in an energized condition of the electronic component (1) provides an output voltage of more than 50mV, 100mV or more than 200mV, and
e) the electronic component (1) does not need any external power supply due to the integral power supply unit (23).

14. The electronic component (1) according to any one of the preceding claims, **characterized in that**
a) the connection parts (3, 4) and/or the resistance element (5) are plate-shaped, in particular in a planar or bent form, and
b) the connection parts (3, 4) are welded to the resistance element (5), in particular by electron beam welding, and
c) the conductor material of the connection parts (3, 4) is copper or a copper alloy, and
d) the conductor material of the connection parts (3, 4) has a specific electrical resistance of less than 5·10⁻⁷Ωm, 2·10⁻⁷Ωm, 1·10⁻⁷Ωm, 5·10⁻⁸Ωm or 2·10⁻⁸Ωm, and
e) the resistance material of the resistance element (5) is a resistance alloy, in particular copper-manganesenickel, in particular Cu84Ni4Mn12, nickel-chromium, nickel-chromium-aluminum-silicone, copper-nickel, nickel-iron, copper-nickel-manganese or copper-nickel, and
f) the resistance material of the resistance element (5) is low-ohmic, in particular with a specific electrical resistance of less than 50·10⁻⁷Ωm, 20·10⁻⁷Ωm, 10·10⁻⁷Ωm or 5·10⁻⁷Ωm, and
g) the resistance material of the resistance element (5) has a high temperature constancy concerning its specific electrical resistance, in particular with a linear temperature coefficient of less than 1·10⁻³K⁻¹, 0.5·10⁻³K⁻¹, 0.2·10⁻³K⁻¹, 0.1·10⁻³K⁻¹, 0.05·10⁻³K⁻¹ or 0.03·10⁻³K⁻¹, and
h) the resistance material of the resistance element (5) has a different thermoelectric power in the thermoelectric potential series than the conductive material of the connection parts (3, 4), and
i) the resistance material of the resistance element (5) has a lower thermal conductivity than the conductor material of the connection parts (3, 4), and
j) the thermal conductivity of the resistance material of the resistance element (5) is less than 100Wm⁻¹K⁻¹, 50Wm⁻¹K⁻¹ or 25Wm⁻¹K⁻¹ and/or greater than 1Wm⁻¹K⁻¹, 2Wm⁻¹K⁻¹, 5Wm⁻¹K⁻¹, 10Wm⁻¹K⁻¹ or 20Wm⁻¹K⁻¹, and
k) the thermal conductivity of the conductor material of the connection parts (3, 4) is greater than 100Wm⁻¹K⁻¹, 200Wm⁻¹K⁻¹ or 300Wm⁻¹K⁻¹ and/or less than 2000Wm⁻¹K⁻¹, 1000Wm⁻¹K⁻¹ or 500Wm⁻¹K⁻¹. and
l) the resistance material has a higher impedance than the conductor material, in particular with a specific electrical resistance of more than 10·10⁻⁸Ωm, 20·10⁻⁸Ωm, 50·10⁻⁸Ωm, 10·10⁻⁷Ωm oder 20·10⁻⁷Ωm.

## Revendications

1. Composant électronique (1), à savoir capteur de courant, comprenant
a) un élément résistif (5) constitué d'un matériau de résistance,
b) une première partie de connexion (3) constituée d'un matériau conducteur servant à introduire un courant électrique (I) dans l'élément résistif (5), et
c) une deuxième partie de connexion (4) constituée d'un matériau conducteur servant à évacuer le courant électrique (I) de l'élément résistif (5),
d) sachant que le matériau conducteur des parties de connexion (3, 4) présente une résistance électrique spécifique plus petite que le matériau de résistance de l'élément résistif (5), et
e) un système de détection de valeurs de mesure, qui est configuré pour mesurer le courant électrique (I) traversant le composant électronique (1), sachant que le système de détection des valeurs de mesure est intégré du point de vue de sa structure dans le composant électronique (1),
**caractérisé en ce**
f) que le système de détection de valeurs de mesure est configuré pour mesurer le courant électrique (I) traversant le composant électronique (1) selon plusieurs différents principes physiques de mesure, à savoir
g) d'une part par une mesure à quatre conducteurs, sachant que le courant électrique à mesurer est acheminé à travers l'élément résistif par l'intermédiaire de deux contacts de connexion, tandis que la tension électrique est mesurée par l'intermédiaire de deux autres contacts de connexion, laquelle tension chute au-dessus de l'élément résistif, et
h) d'autre part par une mesure au moins d'une différence de température (ΔT) entre l'élément résistif (5) d'une part et l'une des deux parties de connexion (3, 4) d'autre part.

2. Composant électronique selon la revendication 1,
**caractérisé par** un système de mesure de température (8) servant à mesurer la différence de température (ΔT) entre l'élément résistif (5) d'une part et au moins l'une des deux parties de connexion (3, 4) d'autre part.

3. Composant électronique (1) selon la revendication 2, **caractérisé en ce que** le système de mesure de température (8) présente au moins un couple thermoélectrique présentant un point de contact chaud (13) et un point de contact froid (14, 15), sachant que le point de contact chaud (13) établit un contact thermique avec l'élément résistif (5), tandis que le point de contact froid (14, 15) établit un contact thermique avec l'une des deux parties de connexion (3, 4).

4. Composant électronique (1) selon la revendication 3,
**caractérisé en ce**
a) **que** le système de mesure de température (8) présente une colonne thermométrique (9, 9.1, 9.2) dotée de plusieurs couples thermoélectriques, qui sont branchés les uns derrière les autres de manière électrique, et
b) **que** les points de contact chauds (13) des couples thermoélectriques établissent respectivement un contact thermique avec l'élément résistif (5), et
c) **que** les points de contact froids (14, 15) des couples thermoélectriques établissent un contact thermique en alternance avec la première partie de connexion (3) et la deuxième partie de connexion (4).

5. Composant électronique (1) selon la revendication 3,
**caractérisé en ce**
a) **que** le système de mesure de température (8) présente une première colonne thermométrique (9.1) et une deuxième colonne thermométrique (9.2),
b) **que** les points de contact chauds (13) des deux colonnes thermométriques (9.1, 9.2) établissent respectivement un contact thermique avec l'élément résistif (5),
c) **que** les points de contact froids (15) de la première colonne thermométrique (9.1) établissent un contact thermique avec la première partie de connexion (3),
d) **que** les points de contact froids (14) de la deuxième colonne thermométrique (9.2) établissent un contact thermique avec la deuxième partie de connexion (4).

6. Composant électronique (1) selon la revendication 5,
**caractérisé en ce**
a) **que** les deux colonnes thermométriques (9.1, 9.2) sont branchées l'une à l'autre sur le composant (1) de manière à former un circuit électrique en série et sont reliées sur le composant (1) de manière électrique à deux contacts communs de connexion, ou
b) **que** les deux colonnes thermométriques (9.1, 9.2) sont séparées l'une de l'autre électriquement sur le composant (1) et, une fois séparées l'une de l'autre électriquement, sont reliées électriquement à respectivement deux contacts de connexion, afin de pouvoir mesurer séparément les tensions thermiques des deux colonnes thermométriques.

7. Composant électronique (1) selon l'une quelconque des revendications 4 à 5, **caractérisé en ce**
a) **que** les points de contact chauds (13) des couples thermoélectriques sont juxtaposés sur l'élément résistif (5) en une rangée, sachant que la rangée des points de contact chauds (13) s'étend essentiellement de manière transversale par rapport à la direction du courant ou
b) **que** les points de contact chauds (13) des couples thermoélectriques sont disposés de manière répartie sur l'élément résistif (5).

8. Composant électronique (1) selon l'une quelconque des revendications précédentes, **caractérisé en ce**
a) **que** le système de mesure de température (8) réagit avec une première constante temporelle définie à une modification dans le temps de la différence de température (ΔT), sachant que la première constante temporelle est supérieure à 0,5s, 1s, 2s, 5s ou 10s, et
b) **que** le système de mesure de température (8) détermine et analyse la modification dans le temps de la différence de température (ΔT) mesurée, et
c) **que** le système de mesure de température (8) est séparé de manière galvanique des parties de connexion (3, 4) et de l'élément résistif (5), et
d) **que** le système de mesure de température (8) est intégré du point de vue de sa structure dans le composant électronique (1), et
e) **que** le système de mesure de température (8) présente une unité d'évaluation (20) qui détermine à partir de la différence de température (ΔT) mesurée, le courant électrique (I) ou la puissance électrique, qui traverse le composant électronique (1), et
f) **que** le système de mesure de température (8) présente une carte de circuit imprimé (10) qui est fixée au niveau des parties de connexion (3, 4) et/ou au niveau de l'élément résistif (5).

9. Composant électronique (1) selon l'une quelconque des revendications 2 à 8, **caractérisé par** un élément de commutation (22) pouvant être commandé, sachant que l'élément de commutation (22) est relié au système de mesure de température (8) et procède à la commutation en fonction de la différence de température (ΔT) mesurée.

10. Composant électronique (1) selon la revendication 9,
**caractérisé en ce**
a) **que** l'élément de commutation (22) pouvant être commandé est un relais, en particulier (22) un relais bistable, et
b) **que** l'élément de commutation (22) est branché en série de manière électrique avec l'élément résistif (5), et
c) **que** l'élément de commutation (22) s'ouvre lorsque la différence de température (ΔT) mesurée par le système de mesure de température (8) dépasse une valeur maximale prédéfinie, et
d) **que** l'élément de commutation (22) se ferme lorsque la différence de température (ΔT) mesurée par le système de mesure de température (8) n'atteint pas une valeur minimale prédéfinie, et
e) **que** l'élément de commutation (22) est intégré du point de vue de sa structure dans le composant électronique (1).

11. Composant électronique (1) selon l'une quelconque des revendications précédentes, **caractérisé par** une unité de mesure de tension (6), qui mesure la tension électrique, qui chute au-dessus de l'élément résistif (5).

12. Composant électronique (1) selon la revendication 11,
**caractérisé en ce**
a) **que** l'unité de mesure de tension (6) est intégrée du point de vue de sa structure dans le composant électronique (1), et
b) **que** l'unité de mesure de tension (6) présente une carte de circuit imprimé (7), qui est fixée a niveau des parties de connexion (3, 4) et/ou au niveau de l'élément résistif (5), et
c) **que** l'unité de mesure de tension (6) présente deux systèmes de prise de tension, qui sont reliés électriquement aux deux parties de connexion (3, 4) afin de mesurer la chute de tension au-dessus de l'élément résistif (5), et
d) **que** l'unité de mesure de tension (6) d'une part et le système de mesure de température (8) d'autre part sont disposés sur des côtés se faisant face du composant électronique (1), et
e) **que** l'unité de mesure de tension (6) réagit avec une deuxième constante temporelle définie à une modification dans le temps du courant électrique (I) traversant le composant électronique (1), sachant que la deuxième constante temporelle est inférieure à la première constante temporelle du système de mesure de température (8) et/ou est inférieure à 100 ms, 50 ms, 20 ms ou à 10 ms.

13. Composant électronique (1) selon l'une quelconque des revendications 2 à 12, **caractérisé en ce**
a) **qu'**une unité d'alimentation en courant (23) est prévue, laquelle alimente en courant électrique nécessaire au fonctionnement le système de mesure de température (8) et/ou l'unité de mesure de tension (6) et/ou l'élément de commutation (22) pouvant être commandé, et
b) **que** l'unité d'alimentation en courant (23) est alimentée par la colonne thermométrique (9, 9.1, 9.2), et
c) **que** la colonne thermométrique (9, 9.1, 9.2) présente plus de 20, 50, 100, 200, 500 ou plus de 1000 couples thermoélectriques, et
d) **que** la colonne thermométrique (9, 9.1, 9.2), lorsque le composant électronique (1) est alimenté en courant, fournit une tension de sortie supérieure à 50 mV, 100 mV, ou supérieure à 200 mV, et
e) **que** le composant électronique (1) ne requiert aucune alimentation externe en courant du fait de l'unité d'alimentation en courant (23) intégrée.

14. Composant électronique (1) selon l'une quelconque des revendications précédentes, **caractérisé en ce**
a) **que** les parties de connexion (3, 4) et/ou l'élément résistif (5) présentent une forme de carte, en particulier sont de forme plane ou de forme incurvée, et
b) **que** les parties de connexion (3, 4) sont soudées à l'élément résistif (5), en particulier par un soudage par faisceau d'électrons, et
c) **que** le matériau conducteur des parties de connexion (3, 4) est du cuivre ou un alliage de cuivre, et
d) **que** le matériau conducteur des parties de connexion (3, 4) présente une résistance électrique spécifique inférieure à 5.10⁻⁷ Ωm, 2.10⁻⁷ Ωm, 1.10⁻⁷ Ωm, 5.10⁻⁸ Ωm ou 2.10⁻⁸ Ωm, et
e) **que** le matériau de résistance de l'élément résistif (5) est un alliage de résistance, en particulier du cuivre-manganèse-nickel, en particulier du Cu84Ni5Mn12, du nickel-chrome, du nickel-chrome-aluminium-silicium, du cuivre-nickel, du nickel-fer, du cuivre-nickel-manganèse ou du cuivre-nickel, et
f) **que** le matériau de résistance de l'élément résistif (5) présente une valeur ohmique basse, en particulier présente une résistance électrique spécifique inférieure à 50.10⁻⁷ Ωm, 20.10⁻⁷ Ωm, 10.10⁻⁷ Ωm ou 5.10⁻⁷ Ωm, et
g) **que** le matériau de résistance de l'élément résistif (5) présente une constante de température élevée concernant sa résistance électrique spécifique, en particulier avec un coefficient de température linéaire inférieur à 1.10⁻³K⁻¹, 0,5.10⁻³K⁻¹, 0,2.10⁻³K⁻¹, 0,1.10⁻³K⁻¹, 0,05.10⁻³K⁻¹ ou 0,03.10⁻³K⁻¹, et
h) **que** le matériau de résistance de l'élément résistif (5) présente dans la série de tension thermoélectrique une autre force thermoélectrique que le matériau conducteur des parties de connexion (3, 4), et
i) **que** le matériau de résistance de l'élément résistif (5) présente une conductivité thermique plus petite que le matériau conducteur des parties de connexion (3, 4), et/ou
j) **que** la conductivité thermique du matériau de résistance de l'élément résistif (5) est inférieure à 100 Wm⁻¹K⁻¹, 50 Wm⁻¹K⁻¹ ou 25 Wm⁻¹K⁻¹ et est supérieure à 1 Wm⁻¹K⁻¹, 2 Wm⁻¹K⁻¹, 5 Wm⁻¹K⁻¹, 10 Wm⁻¹K⁻¹ ou 20 Wm⁻¹K⁻¹, et
k) **que** la conductivité thermique du matériau conducteur des parties de connexion (3, 4) est supérieure à 100 Wm⁻¹K⁻¹, 200 Wm⁻¹K⁻¹ ou 300 Wm⁻¹K⁻¹ et inférieure à 2000 Wm⁻¹K⁻¹, 1000 Wm⁻¹K⁻¹ ou 500 Wm⁻¹K⁻¹, et
l) que le matériau de résistance présente une valeur ohmique plus élevée que le matériau conducteur, en particulier présente une résistance électrique spécifique supérieure à 10.10-⁸ Ωm, 20.10⁻⁸ Ωm, 50.10⁻⁸ Ωm, 10.10⁻⁷ Ωm ou 20.10⁻⁷ Ωm.
